# EUROPEAN PATENT APPLICATION

(11) **EP 4 776 781 A1**
(43) Date of publication of application: **15.07.2026**
(21) Application number: 25729209.4
(22) Date of filing: 18.02.2025
(51) Int. Cl.: H10B 12/00

(54) **SEMICONDUCTOR DEVICE, AND PREPARATION METHOD FOR SEMICONDUCTOR DEVICE**

(30) Priority: 20.11.2024 CN 202411669370
(71) Applicant: CXMT Corporation, Hefei, Anhui 230601 (CN)
(72) Inventor: CHEN, Wenjing, Hefei, Anhui 230601 (CN); HUANG, Meng, Hefei, Anhui 230601 (CN); WANG, Cheng, Hefei, Anhui 230601 (CN); DONG, Haiyang, Hefei, Anhui 230601 (CN); WU, Jiajia, Hefei, Anhui 230601 (CN); WANG, Yanqin, Hefei, Anhui 230601 (CN)
(74) Representative: Gulde & Partner
(86) International application number: PCT/CN2025/077781
(87) International publication number: WO 2026/107992

(57) **Abstract**

A semiconductor device and a manufacturing method for a semiconductor device are disclosed. The semiconductor device includes: a word line, where the word line extends in a direction perpendicular to a substrate; multiple channel layers, where the multiple channel layers surround the word line and each have an annular horizontal cross-section surrounding the word line in a top view; multiple bit lines, where the multiple bit lines each are disposed at one end of each of the multiple channel layers in a first direction; multiple capacitors, where the multiple capacitors each are disposed at the other end of each of the multiple channel layers in the first direction and each have an annular horizontal cross-section in a top view, and the multiple capacitors are spaced apart from each other in the direction perpendicular to the substrate; and multiple protective layers, where the multiple protective layers are disposed between two capacitors adjacent to each other in the direction perpendicular to the substrate, and are located at ends that are of the multiple capacitors and that are close to the multiple channel layers in the first direction. In this way, the channel layers can be prevented from being affected by a thermal budget of a process for manufacturing the capacitors, thereby improving a density and performance of a three-dimensional memory.

## Description

### CROSS-REFERENCE TO RELATED APPLICATIONS

This disclosure is based on and claims priority of the Chinese Invention Patent Application No. 202411669370.4, filed on November 20, 2024 and entitled "SEMICONDUCTOR DEVICE AND MANUFACTURING METHOD FOR SEMICONDUCTOR DEVICE". The above-referenced Chinese Invention Patent Application is incorporated herein by reference in its entirety.

### TECHNICAL FIELD

This application relates to the field of integrated circuit technologies, and in particular, to a semiconductor device and a manufacturing method for a semiconductor device.

### BACKGROUND

Due to development of electronic technologies, miniaturization of semiconductor devices is rapidly developed. A three-dimensional memory is widely concerned and studied because of a small occupied area, a high storage density, and low production costs per memory cell.

However, as a quantity of memory cell layers stacked in the three-dimensional memory becomes increasingly large, a density becomes increasingly large, a distance between a capacitor and a channel layer in the three-dimensional memory becomes increasingly small, and a thermal budget of a capacitor manufacturing process has an increasingly significant impact on the channel layer, which affects performance of the three-dimensional memory, and also increases manufacturing difficulty of the three-dimensional memory.

### SUMMARY

Based on this, embodiments of this application provide a semiconductor device and a manufacturing method for a semiconductor device, so that a channel layer in a three-dimensional memory can be protected to prevent the channel layer from being affected by a thermal budget of a capacitor manufacturing process, thereby improving a density and performance of the three-dimensional memory.

According to a first aspect, this application provides a semiconductor device according to some embodiments, including:
a word line, where the word line extends in a direction perpendicular to a substrate;
multiple channel layers, where the multiple channel layers surround the word line and each have an annular horizontal cross-section surrounding the word line in a top view, and the multiple channel layers are spaced apart from each other in the direction perpendicular to the substrate;
multiple bit lines, where the multiple bit lines each are disposed at one end of each of the multiple channel layers in a first direction, extend in a second direction, and are spaced apart from each other in the direction perpendicular to the substrate, and the first direction and the second direction are perpendicular to each other;
multiple capacitors, where the multiple capacitors each are disposed at the other end of each of the multiple channel layers in the first direction and each have an annular horizontal cross-section in a top view, and the multiple capacitors are spaced apart from each other in the direction perpendicular to the substrate; and
multiple protective layers, where the multiple protective layers are disposed between two capacitors adjacent to each other in the direction perpendicular to the substrate, and are located at ends that are of the multiple capacitors and that are close to the multiple channel layers in the first direction.

In some embodiments, the multiple capacitors include:
multiple lower electrode layers, where the multiple lower electrode layers are respectively electrically connected to the multiple channel layers, the multiple lower electrode layers each have an annular horizontal cross-section, and the multiple lower electrode layers each include a vertical section with a U shape rotated by 90 degrees;
an upper electrode layer, where the upper electrode layer extends in the direction perpendicular to the substrate and is located in annular holes of the multiple lower electrode layers; and
a capacitor dielectric layer, where the capacitor dielectric layer is located between the multiple lower electrode layers and the upper electrode layer.

In some embodiments, the upper electrode layer includes multiple first protrusions located in the U shapes rotated by 90 degrees in the multiple lower electrode layers, the multiple first protrusions each have an annular horizontal cross-section, and U-shaped grooves of the lower electrode layers conformally cover the first protrusions.

In some embodiments, the upper electrode layer further includes multiple second protrusions, the multiple second protrusions are disposed between the multiple lower electrode layers in the direction perpendicular to the substrate, the multiple second protrusions each have a horizontal cross-section of a sector shape, and a central angle of the sector shape faces a direction away from the capacitors.

In some embodiments, the multiple protective layers are disposed between the multiple lower electrode layers in the direction perpendicular to the substrate, and the multiple protective layers are alternately disposed with the multiple lower electrode layers.

In some embodiments, the multiple protective layers each include a vertical section with a U shape rotated by 90 degrees, and an opening direction of the U-shaped vertical section of each of the multiple protective layers is opposite to an opening direction of the U-shaped vertical section of each of the multiple lower electrode layers in the first direction.

In some embodiments, the capacitor dielectric layer conformally overlaps surfaces of the first protrusions and the second protrusions of the upper electrode layer.

In some embodiments, a horizontal section of the word line has a circular shape or an oval shape, the word line has a cross-section with multiple protrusions in the direction perpendicular to the substrate, and the multiple channel layers surround the word line and are disposed between the multiple protrusions.

In some embodiments, each of the channel layers includes an oxide semiconductor material, a group IV semiconductor material, a group III-V compound semiconductor material, an epitaxial semiconductor material, or a two-dimensional semiconductor material.

In some embodiments, each of the channel layers includes a first doped region at one end in contact with a bit line and a second doped region at the other end in contact with a capacitor in the first direction.

According to second aspect, this application further provides a manufacturing method for a semiconductor device according to some embodiments, including the steps as follows.

A substrate is provided, and a word line is formed on the substrate, where the word line extends in a direction perpendicular to the substrate.

Multiple channel layers are formed, where the multiple channel layers surround the word line and each have an annular horizontal cross-section surrounding the word line in a top view, and the multiple channel layers are spaced apart from each other in the direction perpendicular to the substrate.

Multiple bit lines are formed, where the multiple bit lines each are disposed at one end of each of the multiple channel layers in a first direction, extend in a second direction, and are spaced apart from each other in the direction perpendicular to the substrate, and the first direction and the second direction are perpendicular to each other.

Multiple capacitors are formed, where the multiple capacitors each are disposed at the other end of each of the multiple channel layers in the first direction and each have an annular horizontal cross-section in a top view, and the multiple capacitors are spaced apart from each other in the direction perpendicular to the substrate.

Multiple protective layers are formed, where the multiple protective layers are disposed between two capacitors adjacent to each other in the direction perpendicular to the substrate, and are located at ends that are of the multiple capacitors and that are close to the multiple channel layers in the first direction.

In some embodiments, before the bit line is formed, the method includes the steps as follows.

The substrate is provided, and a stacked structure in which multiple first dielectric layers and second dielectric layers are alternately stacked is formed on the substrate.

The stacked structure is etched to form a bit line groove, and the bit line is formed in the bit line groove.

In some embodiments, that a capacitor is formed includes the steps as follows.

The stacked structure is etched to form a capacitor through-hole and a word line through-hole, multiple lower electrode layers are formed in the capacitor through-hole, and multiple protective layers are formed in the word line through-hole.

A capacitor dielectric layer and an upper electrode layer are formed in the capacitor through-hole.

In some embodiments, that a word line is formed includes the step as follows.

Multiple channel layers are formed in and a word line conductive material is filled in the word line through-hole.

The semiconductor structure and the manufacturing method therefor provided in this application have at least the following beneficial effects:
According to the semiconductor device and the manufacturing method for a semiconductor device provided in this application, the multiple protective layers in the semiconductor device are disposed between two capacitors adjacent to each other in the direction perpendicular to the substrate, and are located in regions at the ends that are of the multiple capacitors and that are close to the multiple channel layers in the first direction, to prevent the channel layers from being affected by a thermal budget of a process for manufacturing the capacitors, thereby improving a density and performance of a three-dimensional memory.

### BRIEF DESCRIPTION OF DRAWINGS

To describe the technical solutions in the embodiments of this application or the conventional technologies more clearly, the following briefly describes the accompanying drawings required for describing the embodiments or the conventional technologies. Clearly, the accompanying drawings in the following description show merely some embodiments of this application, and a person of ordinary skill in the art may still derive other drawings from these accompanying drawings without creative efforts.
FIG. 1 is a three-dimensional schematic diagram of a semiconductor device according to an embodiment of this application;
FIG. 2 is a top view of a partial region of FIG. 1;
FIG. 3 is a schematic diagram of a cross-section along AA in FIG. 2; and
FIG. 4 to FIG. 10 are three-dimensional schematic diagrams of a manufacturing method for forming a semiconductor device according to an embodiment of this application;

Descriptions of reference numerals:
100: substrate; 101: first dielectric layer; 102: second dielectric layer; 200: bit line; 300: capacitor; 301: lower electrode layer; 302: capacitor dielectric layer; 303: upper electrode layer; 3031: first protrusion; 3032: second projection; 304: capacitor wire; 400: protective layer; 501: word line; 502: gate oxide layer; 600: channel layer; 700: isolation layer; T1: capacitor through-hole; T2: word line through-hole; and T3: bit line groove.

### DESCRIPTION OF EMBODIMENTS

For ease of understanding of this application, this application is described more comprehensively below with reference to related accompanying drawings. A preferred embodiment of this application is provided in the accompanying drawings. However, this application may be implemented in many different forms, and is not limited to the embodiments described herein. Instead, these embodiments are provided to make the content of this application more thorough and comprehensive.

Unless otherwise defined, all technical and scientific terms utilized in the specification have meanings the same as those commonly understood by a person skilled in the art of this application. In this application, terms utilized in the specification of this application are merely intended to describe objectives of specific embodiments, but are not intended to limit this application.

It should be understood that an element or a layer may be directly on or adjacent or connected to another element or layer or there may be an intermediate element or layer when the element or the layer is referred to as "on...", "adjacent to...", or "connected to...". It should be understood that although the terms "first", "second", and the like may be utilized to describe various elements, components, regions, layers, doping types, and/or portions, these elements, components, regions, layers, doping types, and/or portions should not be limited by these terms. These terms are merely utilized to distinguish one element, component, region, layer, doping type, or portion from another element, component, region, layer, doping type, or portion. Therefore, without departing from the teachings of this application, a first element, component, region, layer, doping type, or portion discussed below may be represented as a second element, component, region, layer, or portion. For example, a first doped region may be referred to as a second doped region, and similarly, a second doped region may be referred to as a first doped region. The first doped region and the second doped region are different doped regions.

Spatial relationship terms, e.g., "above...", may be utilized herein to describe a relationship between one element or feature and another element or feature shown in the figures. It should be understood that in addition to the orientations shown in the figures, the spatial relationship terms further include different orientations of devices in application and operation. For example, an element or a feature described as "above..." is oriented to be "below" another element or feature if the devices in the accompanying drawings are flipped. Therefore, the example terms "above..." may include orientations of being above and being below. In addition, the devices may alternatively include other orientations (e.g., rotation by 90 degrees or another orientation), and the spatial descriptors employed herein are interpreted accordingly.

As employed herein, the singular forms of "a", "an", and "the" may also be intended to include plural forms unless otherwise clearly specified in the context. It should also be understood that, the presence of the feature, integer, step, operation, element, and/or component can be determined without ruling out the presence or addition of one or more other features, integers, steps, operations, elements, components, and/or groups when the term "constitute" and/or the term "include" are/is employed in the specification. Moreover, as employed herein, the term "and/or" includes any and all combinations of the related items listed.

The embodiments of the invention are described herein with reference to a cross-sectional view serving as a schematic diagram of an ideal embodiment (and an intermediate structure) of this application. In this way, a variation in the shown shape caused by, e.g., a manufacturing technology and/or a tolerance can be expected. Therefore, the embodiments of this application should not be limited to specific shapes of the regions shown herein, but include a shape deviation caused by, e.g., a manufacturing technology. The regions shown in the figure are essentially examples. The shapes of the regions do not represent actual shapes of the regions of the device, and do not limit the scope of this application.

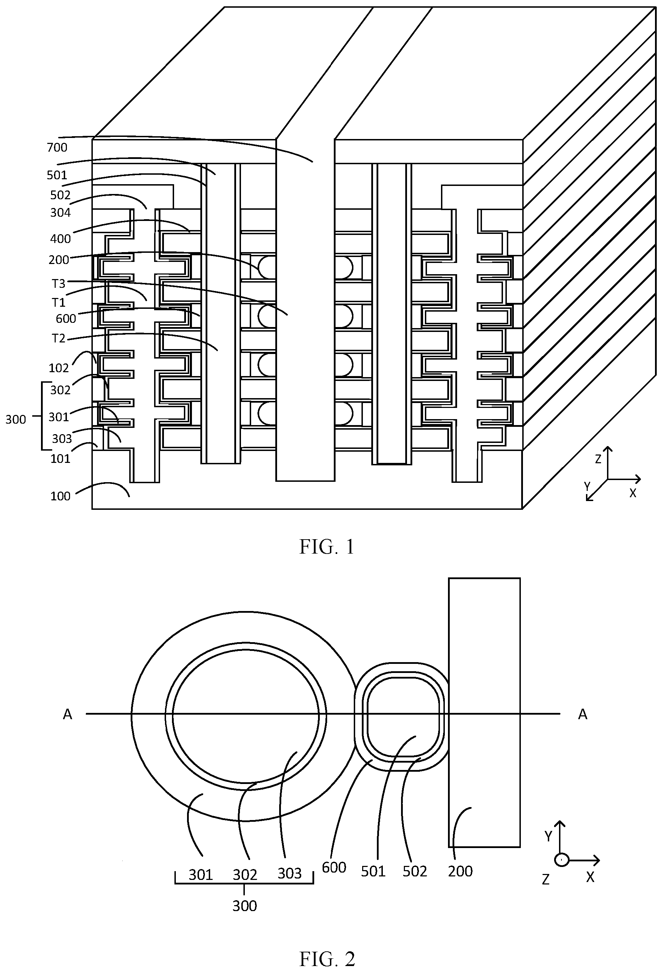

FIG. 1 is a three-dimensional schematic diagram of a semiconductor device according to an embodiment of this application. In some embodiments, the semiconductor device includes: a word line 501, where the word line 501 extends in a direction (e.g., a Z direction) perpendicular to a substrate; multiple channel layers 600, where the multiple channel layers 600 surround the word line 501 and each have an annular horizontal cross-section surrounding the word line 501 in a top view, and the multiple channel layers 600 are spaced apart from each other in the direction (e.g., the Z direction) perpendicular to the substrate; multiple bit lines 200, where the multiple bit lines 200 each are disposed in a first direction (e.g., an X direction) at one end of each of the multiple channel layers 600, extend in a second direction (e.g., a Y direction), and are spaced apart from each other in the direction (e.g., the Z direction) perpendicular to the substrate, and the first direction (e.g., the X direction) and the second direction (e.g., the Y direction) are perpendicular to each other; multiple capacitors 300, where the multiple capacitors 300 each are disposed in the first direction (e.g., the X direction) at the other end of each of the multiple channel layers 600 and each have an annular horizontal cross-section in a top view, and the multiple capacitors 300 are spaced apart from each other in the direction (e.g., the Z direction) perpendicular to the substrate; and multiple protective layers 400, where the multiple protective layers 400 are disposed between two capacitors 300 adjacent to each other in the direction (e.g., the Z direction) perpendicular to the substrate, and are located at ends that are of the multiple capacitors 300 and that are close to the multiple channel layers in the first direction (e.g., the X direction). The multiple protective layers 400 in the semiconductor device are disposed between two capacitors 300 adjacent to each other in the direction (e.g., the Z direction) perpendicular to the substrate, and are located at the ends that are of the multiple capacitors 300 and that are close to the multiple channel layers in the first direction (e.g., the X direction), so that the channel layers 600 are isolated from the capacitors 300, to prevent the channel layers 600 from being affected by a thermal budget of a process for manufacturing the capacitors 300, thereby improving a density and performance of a three-dimensional memory.

With continued reference to FIG. 1, in some embodiments of this application, the semiconductor device includes the substrate 100, the capacitors 300, the channel layers 600, and the bit lines 200 are stacked in the direction (e.g., the Z direction) perpendicular to the substrate 100, and the word line 501 extends in the direction (e.g., the Z direction) perpendicular to the substrate. The substrate 10 may be a single-crystal silicon wafer, a polysilicon wafer, a germanium-silicon wafer, a sapphire wafer, a silicon carbide wafer, a silicon on insulator wafer, a germanium on insulator wafer, a glass wafer, a group III-V compound wafer (e.g., silicon nitride or gallium arsenide), an oxide semiconductor wafer, or another wafer formed with a semiconductor device. The substrate may be doped with one or more elements of germanium, carbon, phosphorus, boron, arsenic, gallium, or indium, thereby improving a conductive capability of the substrate. Multiple word lines 501 extend in the direction (e.g., the Z direction) perpendicular to the substrate 100, and are distributed in an array on the substrate. A horizontal cross-section of the word line 501 may be in a shape of a circle, an oval, a square, or another polygon pattern. Referring to FIG. 2, FIG. 2 is a top view of a partial region in FIG. 1. In some embodiments, the word line further includes multiple protrusions in the direction perpendicular to the substrate, the channel layers 600 are located between adjacent protrusions, and the multiple protrusions and the channel layers 600 are disposed alternately at intervals, so that the width of the horizontal cross-section of the word line can be increased, conductive resistance of the word line can be reduced, a manufacturing window of the word line can be increased, and stability of the word line can be improved. The word line 501 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. In some embodiments, the word line 501 may include multiple layers, for example, further including a conductive barrier layer. A gate oxide layer 502 is disposed surrounding the word line 501, and conformally covers the word line 501. The gate oxide layer 502 may include at least one material selected from a high k dielectric material or ferroelectric material with a dielectric constant higher than a dielectric constant of silicon oxide. In some embodiments, the gate oxide layer 502 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), hafnium zirconium oxide (HfZrO), hafnium zirconium oxynitride (HfZrON), tantalum oxide (TaO), titanium oxide (TiO), barium strontium titanium oxide (BaSrTiO), barium titanium oxide (BaTiO), lead zirconium titanate (PZT), strontium bismuth tantalum (SBT), bismuth iron oxide (BFO), strontium titanium oxide (SrTiO), yttrium oxide (YO), aluminum oxide (AlO), or lead oxide scandium tantalum (PbScTaO). In some embodiments, the gate oxide layer 502 may include a metal oxide containing a dopant. For example, the dopant may include at least one of zirconium (Zr), gadolinium (Gd), lanthanum (La), silicon (Si), or aluminum (Al), but is not limited thereto. In some examples, the gate oxide layer 502 may include hafnium oxide with a specific concentration of dopant.

With continued reference to FIG. 1 and FIG. 2, the multiple channel layers 600 surround the word line 501 and each have an annular horizontal cross-section surrounding the word line 501. The multiple channel layers 600 are spaced apart from each other in the direction (e.g., the Z direction) perpendicular to the substrate. The horizontal cross-section of each of the channel layers 600 may be in a shape of a circle, an oval, a square, or another polygon. In the first direction, (e.g., the X direction), one end of the channel layer 600 is connected to a capacitor 300 and the other end thereof is connected to a bit line 200. In some embodiments, the material of the channel layer 600 may be single-crystal silicon, polysilicon, doped polysilicon, doped single-crystal silicon, germanium-silicon, doped germanium-silicon, or the like. In some embodiments, the material of the channel layer 600 may include an oxide semiconductor material, a group IV semiconductor material, a group III-V compound semiconductor material, an epitaxial semiconductor material, or a two-dimensional semiconductor material. For example, the material may include an oxide semiconductor material such as an In-Ga oxide (IGO), an In-Zn oxide (IZO), or an In-Ga-Zn oxide (IGZO); may include a group IV semiconductor material such as Si or Ge; may include a group III-V compound semiconductor material such as gallium arsenide (GaAs), indium arsenide (InAs), or indium phosphide (InP); may include an epitaxial semiconductor material formed through a selective epitaxial growth (EG) process; and may include a two-dimensional semiconductor material such as MoS₂, MoSe₂, ReS₂, HfSe₂, InSe, GeSe, WSe₂, graphene, or carbon nanotube. In some embodiments, the channel region 600 may be doped with a variety of ions, such as boron ions, nitrogen ions, phosphorus ions, or other metal ions. One end that is of the channel region 600 and that is connected to the bit line has a first doped region, and the other end that is of the channel region and that is connected to the capacitor 300 has a second doped region. The first doped region and the second doped region may respectively reduce resistance at the connection to the capacitor and the bit line.

With continued reference to FIG. 1 and FIG. 2, in some embodiments, the multiple capacitors 300 each are disposed at the other end of each of the multiple channel layers 600 in the first direction (e.g., the X direction) and each have an annular horizontal cross-section in a top view, and the multiple capacitors 300 are spaced apart from each other in the (e.g., the Z direction) direction perpendicular to the substrate. Each of the capacitors includes a lower electrode layer 301, an upper electrode layer 303, and a capacitor dielectric layer 302 located between the upper electrode layer 303 and the lower electrode layer 301. In some embodiments, the lower electrode layer 301 has an annular horizontal cross-section, which may be in a shape of, e.g., a circle, an oval, a square, or another polygon, and the lower electrode layer is connected to one end of the channel layer 600 in the first direction (e.g., the X direction). The material of the lower electrode layer 301 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like.

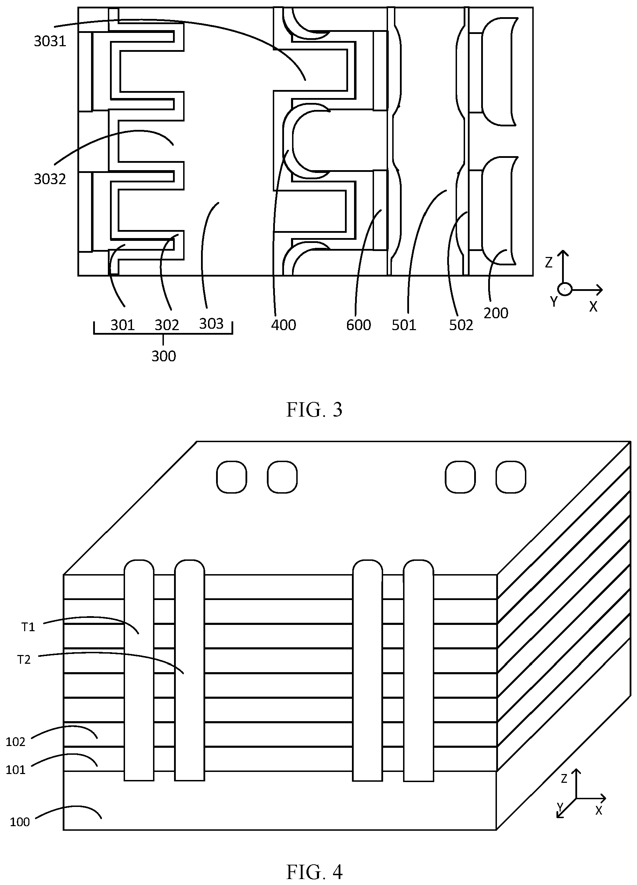

FIG. 3 is a schematic diagram of a cross-section along AA in FIG. 2. With reference to FIG. 1 and FIG. 2, in some embodiments, the lower electrode layer 301 further has a vertical section with a U shape rotated by 90 degrees, and the lower electrode layer 302 includes a first portion extending in the direction (e.g., the Z direction) perpendicular to the substrate and a second portion and a third portion extending in a horizontal direction. The second portion and the third portion are respectively connected to two ends of the first portion to form a U-shaped groove. The first portion, the second portion, and the third portion each have an annular cross-section. In some embodiments, the second portion may extend by different lengths at different angles in the horizontal direction, and the third portion may extend by different lengths at different angles in the horizontal direction. In some embodiments, in the same horizontal direction, a length extended by the second portion in the horizontal direction may be different from a length extended by the third portion in the horizontal direction. Multiple lower electrode layers 301 are stacked in the direction (e.g., the Z direction) perpendicular to the substrate, and there is an interval between the multiple lower electrode layers 301.

With continued reference to FIG. 1, FIG. 2, and FIG. 3, in some embodiments, the upper electrode layer 303 extends in the direction (e.g., the Z direction) perpendicular to the substrate, runs through the multiple lower electrode layers 301, and is located in annular holes of the lower electrode layers 301. The upper electrode layer 303 has a horizontal cross-section in a shape of a ring, an oval, a square, or another polygon, and is conformal with the lower electrode layers 301. In some embodiments, the upper electrode layer 303 further has multiple first protrusions, and the multiple first protrusions 3031 are arranged at intervals in the direction (e.g., the Z direction) perpendicular to the substrate. The multiple first protrusions 3031 each have a horizontal cross-section in a shape of a ring, an oval, a square, or another polygon, are conformal with the lower electrode layers 301, and are located in U-shaped grooves of the lower electrode layers 301. The U-shaped grooves of the lower electrode layers 301 conformally cover the first protrusions 3031. In some embodiments, the upper electrode layer 303 further includes multiple second protrusions 3032, and the multiple second protrusions 3032 are arranged at intervals in the direction (e.g., the Z direction) perpendicular to the substrate. In addition, the first protrusions 3031 and the second protrusions 3032 are arranged at intervals in the direction (e.g., the Z direction) perpendicular to the substrate. The second protrusions 3032 each have a horizontal cross-section of a sector shape. In some embodiments, a central angle of the sector shape faces a direction away from the capacitors, and the central angle may be 60°, 90°, 120°, 150°, 180°, 210°, or another angle. In some embodiments, the material of the upper electrode is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. The material of the upper electrode layer 303 may be the same as or different from the material of the lower electrode layer 301.

With continued reference to FIG. 1, in some embodiments, the semiconductor device further includes a capacitor wire 304. The capacitor wire 304 is connected to the upper electrode layer 303, is located at the upper electrode layer 303, and is connected to multiple upper electrode layers 303 arranged in the second direction. In some embodiments, the capacitor wire 304 may be formed integrally with the upper electrode layer 303. The material of the capacitor wire 304 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like.

With continued reference to FIG. 1, FIG. 2, and FIG. 3, in some embodiments, the capacitor dielectric layer 302 is located between the lower electrode layer 301 and the upper electrode layer 303, and the capacitor dielectric layer 302 is conformally located in the U-shaped groove of the lower electrode layer 301. In some embodiments, the capacitor dielectric layer 302 further conformally covers surfaces of the upper electrode layer 303, the first protrusions 3031, and the second protrusions 3032. The material of the capacitor dielectric layer 302 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconium titanate (PZT), strontium bismuth tantalum (SBT), bismuth iron oxide (BFO), strontium titanium oxide (SrTiO), yttrium oxide (YO), aluminum oxide (Al2O), or lead oxide scandium tantalum (PbScTaO).

With continued reference to FIG. 1, FIG. 2, and FIG. 3, in some embodiments, the semiconductor device further includes multiple protective layers 400. The multiple protective layers 400 are stacked in the direction (e.g., the Z direction) perpendicular to the substrate, are alternately arranged with the multiple lower electrode layers, and are located on surfaces at ends that are of the lower electrode layers and that are in contact with the channel layers. In some embodiments, the protective layer 400 has a horizontal cross-section of a sector shape, and a central angle of the sector shape of the protective layer 400 and a central angle of the second protrusion 3032 are complementary, that is, the central angle of the sector shape of the protective layer 400 and the central angle of the second protrusion 3032 are 360°. In some embodiments, the protective layer 400 has a vertical section with a U shape rotated by 90 degrees in the direction (e.g., the Z direction) perpendicular to the substrate, and an opening direction of the U-shaped vertical section of the protective layer is opposite to an opening direction of the U-shaped vertical section of the lower electrode layer 301 in the first direction. In another embodiment, the protective layer 400 is filled between two lower electrode layers 301 adjacent to each other in the direction (e.g., the Z direction) perpendicular to the substrate, and one end of the protective layer is flush with an end that is of the lower electrode layer 301 and that is away from the channel layer 600. The material of the protective layer 400 is one or more of silicon nitride, silicon oxynitride, silicon carbide, silicon carbonitride, silicon oxycarbide, or silicon oxide.

With continued reference to FIG. 1, FIG. 2, and FIG. 3, in some embodiments, the semiconductor device includes multiple bit lines 200. The multiple bit lines 200 extend in the second direction (e.g., the Y direction), are arranged at intervals in the direction (e.g., the Z direction) perpendicular to the substrate, and each are connected to one end of the channel layer in the first direction (e.g., the X direction). The bit lines 200 are connected to the first doped regions of the channel layers 600. In some embodiments, the protective layer 400 is further located between two bit lines 200 adjacent to each other in the direction (e.g., Z direction) perpendicular to the substrate, and the protective layer 400 and the bit lines 200 are arranged at intervals in the direction (e.g., Z direction) perpendicular to the substrate. In some embodiments, the material of the bit line is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. The bit line 200 may have one layer, or may have multiple layers. In another embodiment, there may be a contact layer between the bit line 200 and the channel layer 600, e.g., a metal silicide layer, which may reduce contact resistance between the bit line 200 and the channel layer 600.

With continued reference to FIG. 1, in some embodiments, the semiconductor device further includes an isolation layer 700. The isolation layer 700 is located on the substrate 100, and isolates adjacent bit lines 200 in the first direction (e.g., the X direction). The material of the isolation layer 700 may be one or more of silicon oxide, silicon nitride, silicon oxynitride, silicon carbide, or silicon carbonitride. In another embodiment, there may further be an air gap in the isolation layer 700, and the air gap may reduce parasitic capacitance between adjacent bit lines 200.

FIG. 4 to FIG. 10 are three-dimensional schematic diagrams of a manufacturing method for forming a semiconductor device according to an embodiment of this application.

Referring to FIG. 4, in some embodiments, a substrate 100 is provided, and a first dielectric layer 101 and a second dielectric layer 102 are sequentially stacked on the surface of the substrate 100, where the first dielectric layer 101 and the second dielectric layer 102 are sequentially stacked in a direction (e.g., a Z direction) perpendicular to the substrate. In some embodiments, the substrate 10 may be a single-crystal silicon wafer, a polysilicon wafer, a germanium-silicon wafer, a sapphire wafer, a silicon carbide wafer, a silicon on insulator wafer, a germanium on insulator wafer, a glass wafer, a group III-V compound wafer (e.g., silicon nitride or gallium arsenide), an oxide semiconductor wafer, or another semiconductor device-formed wafer. The substrate may be doped with one or more elements of germanium, carbon, phosphorus, boron, arsenic, gallium, or indium, thereby improving a conductive capability of the substrate. The first dielectric layer 101 and the second dielectric layer 102 may be one of single-crystal silicon, polysilicon, germanium-silicon, silicon oxide, silicon nitride, or silicon oxynitride. The first dielectric layer 101 and the second dielectric layer 102 are different, and have an etching selectivity ratio. In some embodiments, an etching stop layer may further exist between the first dielectric layer 101 and the substrate 100, and may protect the substrate 100 when the first dielectric layer 101 and the second dielectric layer 102 are etched. A mask layer is formed on a stacked structure of the first dielectric layer 101 and the second dielectric layer 102, to form multiple capacitor through-holes T1 and multiple word line through-holes T2 through patterned etching. The multiple capacitor through-holes T1 and the multiple word line through-holes T2 run through the stacked structure of the first dielectric layer 101 and the second dielectric layer 102. The multiple capacitor through-holes T1 are arranged in an array in a first direction (e.g., an X direction) and a second direction (e.g., a Y direction), and the capacitor through-holes T1 and the word line through-holes T2 are arranged alternately in the first direction (e.g., the X direction). In some embodiments, a horizontal cross-section of each of the capacitor through-holes T1 and the word line through-holes T2 is in a shape of a circle, an oval, a square, or another polygon. A horizontal cross-section shape of the capacitor through-hole T1 may be different from or may be different from a horizontal cross-section pattern of the word line through-hole T2. A sacrificial layer is filled in the capacitor through-hole T1 and the word line through-hole T2, and is polished and flattened. The sacrificial layer may be spin-on carbon, a silicon oxide compound, or another material that is easily etched for removed.

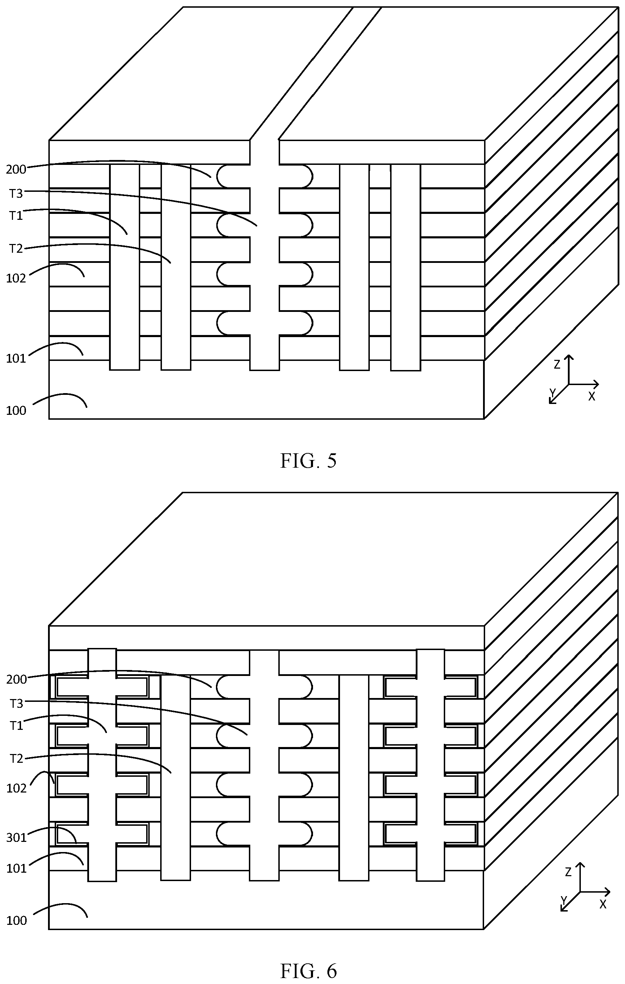

Referring to FIG. 5, in some embodiments, a mask layer is formed on the stacked structure of the first dielectric layer 101 and the second dielectric layer 102 to form a bit line groove T3 through patterned etching, where the bit line groove T3 runs through the stacked structure of the first dielectric layer 101 and the second dielectric layer 102, and segments the stacked structure of the first dielectric layer 101 and the second dielectric layer 102 in the first direction (e.g., the X direction). In some embodiments, in a process of forming the bit line groove T3, an etching condition is adjusted, and the second dielectric layers 102 on both sides of the bit line groove T3 are selectively removed, so that the formed bit line groove T3 exposes the word line through-holes T2. A conductive material is filled in the bit line groove T3, and is polished and flattened to form a bit line 200. The bit line 200 is filled in a gap in which the second dielectric layer 102 is removed and a part that is of the bit line groove T3 and that is perpendicular to the direction (e.g., the Z direction) of the substrate. The material of the bit line 200 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. The bit line 200 may have one layer, or may have multiple layers. In another embodiment, there may be a contact layer between the bit line 200 and a channel layer 600, e.g., a metal silicide layer, which may reduce contact resistance between the bit line 200 and the channel layer 600. A method for filling a bit line may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like. In some embodiments, the gap in which the second dielectric layer 102 is removed may be filled first, and then the part that is of the bit line groove T3 and that is perpendicular to the direction (e.g., the Z direction) of the substrate is filled. Alternatively, another multi-step method may be employed. Materials deposited d each time may be the same or may be different.

Referring to FIG. 6, a mask layer is deposited on the surface of the stacked structure of the first dielectric layer 101 and the second dielectric layer 102, and the capacitor through-hole T1 is re-opened through patterned etching, or the capacitor through-hole T1 is re-opened by selectively etching and removing the sacrificial material in the capacitor through-hole T1. In some embodiments, in a process of re-opening to form the capacitor through-hole T1, an etching condition is adjusted and a part of the second dielectric layer 102 around the capacitor through-hole T1 is selectively etched and removed. In some embodiments, a gap left by the removed part of the second dielectric layer 102 has an annular horizontal cross-section surrounding the capacitor through-hole T1, and the annular horizontal cross-section may be in a shape of a circle, an oval, a square, or another polygon. A conductive material is deposited in the gap left by the removed part of the second dielectric layer 102 to form a lower electrode layer 301, and the lower electrode layer 301 conformally covers a sidewall of the gap left by the removed part of the second dielectric layer 102. The lower electrode layer 301 has an annular horizontal cross-section, which may be in a shape of, e.g., a circle, an oval, a square, or another polygon. In some embodiments, the lower electrode layer 301 further has a vertical cross-section with a U shape rotated by 90 degrees. The lower electrode layer 302 includes a first portion extending in the direction (e.g., Z direction) perpendicular to the substrate and a second portion and a third portion extending a horizontal direction. The second portion and the third portion are respectively connected to two ends of the first portion to form a U-shaped groove. In some embodiments, the first portion, the second portion, and the third portion each have an annular cross-section. In some embodiments, the second portion may extend by different lengths at different angles in the horizontal direction, and the third portion may extend by different lengths at different angles in the horizontal direction. In some embodiments, in the same horizontal direction, a length extended by the second portion in the horizontal direction may be different from a length extended by the third portion in the horizontal direction. The multiple lower electrode layers 301 are stacked in the direction (e.g., the Z direction) perpendicular to the substrate, and there is an interval between the multiple lower electrode layers 301. The material of the lower electrode layer 301 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOx), iridium (Ir), iridium oxide (IrOx), tantalum nitride (TaN), cobalt (Co), aluminum (Al), copper (Cu), metal silicide, and the like. A method for forming the lower electrode layer 301 may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like. In some embodiments, an atomic layer deposition (Atomic Layer Deposition, ALD) process may first be utilized to form a layer of conductive material in the capacitor through-hole T1, and then a sidewall of the capacitor through-hole T1 is etched and removed, that is, a part in the direction (e.g., the Z direction) perpendicular to the substrate. In this way, a connection between two lower electrode layers 301 adjacent to each other in the direction (e.g., the Z direction) perpendicular to the substrate may be cut. A sacrificial material layer is filled in, and is polished and flattened.

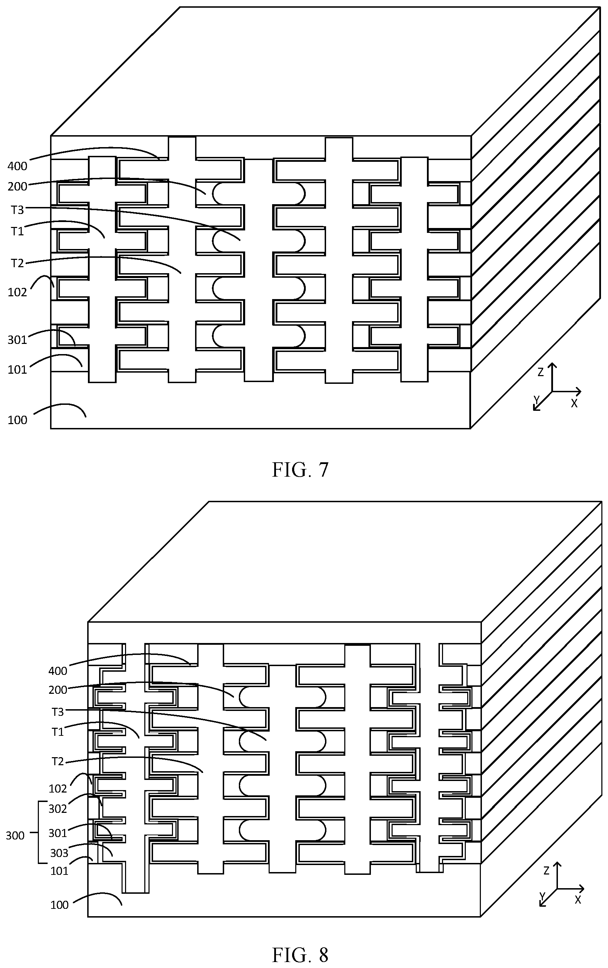

Referring to FIG. 7, in some embodiments, a mask layer is deposited on the surface of the stacked structure of the first dielectric layer 101 and the second dielectric layer 102, and the word line through-hole T2 is re-opened through patterned etching, or the word line through-hole T2 is re-opened by selectively etching and removing the sacrificial material in the word line through-hole T2. In some embodiments, in a process of re-opening to form the word line through-hole T2, an etching condition is adjusted and a part of the first dielectric layer 101 around the word line through-hole T2 is selectively etched and removed. In some embodiments, a gap left by the removed part of the first dielectric layer 101 has an annular horizontal cross-section surrounding the word line through-hole T2, and the annular horizontal cross-section may be in a shape of a circle, an oval, a square, or another polygon. An insulating material is deposited in the gap left by the removed part of the first dielectric layer 101 to form a protective layer 400. The protective layer 400 conformally covers a sidewall of the gap left by the removed part of the first dielectric layer 101. The protective layer 400 has an annular horizontal cross-section, which may be in a shape of, e.g., a circle, an oval, a square, or another polygon. In some embodiments, the protective layer 400 has a vertical section with a U shape rotated by 90 degrees in the direction (e.g., the Z direction) perpendicular to the substrate, and an opening direction of the U-shaped vertical section of the protective layer is opposite to an opening direction of the U-shaped vertical section of the lower electrode layer 301 in the first direction. In another embodiment, the protective layer 400 is fully filled between two lower electrode layers 301 adjacent to each other in the direction (e.g., the Z direction) perpendicular to the substrate, and one end of the protective layer is flush with an end that is of the lower electrode layer 301 and that is away from the channel layer 600. The material of the protective layer 400 is one or more of silicon nitride, silicon oxynitride, silicon carbide, silicon carbonitride, silicon oxycarbide, or silicon oxide. The material of the protective layer 400 is different from the material of the first dielectric layer 101, and there is an etching selectivity ratio between the materials. A method for forming the protective layer 400 may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like. In some embodiments, an atomic layer deposition (Atomic Layer Deposition, ALD) process may first be utilized to form a layer of insulating material in the word line through-hole T2, and then a sidewall of the word line through-hole T2 is etched and removed, that is, a part in the direction (e.g., the Z direction) perpendicular to the substrate. A sacrificial material layer is filled in, and is polished and flattened.

Referring to FIG. 8, in some embodiments, a mask layer is deposited on the stacked structure of the first dielectric layer 101 and the second dielectric layer 102, and the capacitor through-hole T1 is re-opened through patterned etching, or the capacitor through-hole T1 is re-opened by selectively etching and removing the sacrificial material in the capacitor through-hole T1, to exposure the lower electrode layer 301. In some embodiments, in a process of re-opening to form the capacitor through-hole T1, an etching condition is adjusted and a part of the first dielectric layer 101 around the capacitor through-hole T1 is selectively etched and removed. In some embodiments, because the material of the first dielectric layer 101 is different from the material of the protective layer 400, the first dielectric layer 101 may be selectively removed, and the protective layer 400 is reserved. Therefore, a gap left by the removed part of the first dielectric layer 101 has a sector-shaped horizontal cross-section surrounding the capacitor through-hole T1. A conductive material is filled in the capacitor through-hole T1 to form an upper electrode layer 303. In some embodiments, the upper electrode layer 303 extends in the direction (e.g., the Z direction) perpendicular to the substrate, runs through the multiple lower electrode layers 301, and is located in annular holes of the lower electrode layers 301. The upper electrode layer 303 has a horizontal cross-section in a shape of a ring, an oval, a square, or another polygon, and is conformal with the lower electrode layers 301. In some embodiments, the upper electrode layer 303 further has multiple first protrusions, and the multiple first protrusions 3031 are arranged at intervals in the direction (e.g., the Z direction) perpendicular to the substrate. The multiple first protrusions 3031 each have a horizontal cross-section in a shape of a ring, an oval, a square, or another polygon, are conformal with the lower electrode layers 301, and are located in U-shaped grooves of the lower electrode layer 301. The U-shaped grooves of the lower electrode layers 301 conformally cover the first protrusions 3031. In some embodiments, the upper electrode layer 303 further includes multiple second protrusions 3032, the multiple second protrusions 3032 are at a location at which a part of the first dielectric layer 101 around the capacitor through-hole T1 is removed, and the multiple second protrusions 3032 are arranged at intervals in the direction (e.g., the Z direction) perpendicular to the substrate. In addition, the first protrusions 3031 and the second protrusions 3032 are arranged at intervals in the direction (e.g., the Z direction) perpendicular to the substrate. The second protrusions 3032 each have a horizontal cross-section of a sector shape. In some embodiments, a central angle of the sector shape faces a connection from the capacitors, and the central angle may be 60°, 90°, 120°, 150°, 180°, 210°, or another angle. Reference may be made to FIG. 2 and FIG. 3. In some embodiments, the material of the upper electrode is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. The material of the upper electrode layer 303 may be the same as or different from the material of the lower electrode layer 301. A method for forming the upper electrode layer 303 may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like.

With continued reference to FIG. 8, FIG. 2, and FIG. 3, in some embodiments, before the upper electrode 303 is deposited, a capacitor dielectric layer 302 is further deposited in the capacitor through-hole T1. The capacitor dielectric layer 302 is located between the lower electrode layer 301 and the upper electrode layer 303, and the capacitor dielectric layer 302 conformally covers the U-shaped groove of the lower electrode layer 301. In some embodiments, the capacitor dielectric layer 302 further conformally covers surfaces of the upper electrode layer 303, the first protrusions 3031, and the second protrusions 3032. The material of the capacitor dielectric layer 302 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconium titanate (PZT), strontium bismuth tantalum (SBT), bismuth iron oxide (BFO), strontium titanium oxide (SrTiO), yttrium oxide (YO), aluminum oxide (Al2O), or lead oxide scandium tantalum (PbScTaO). A method for forming the capacitor dielectric layer 302 may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like.

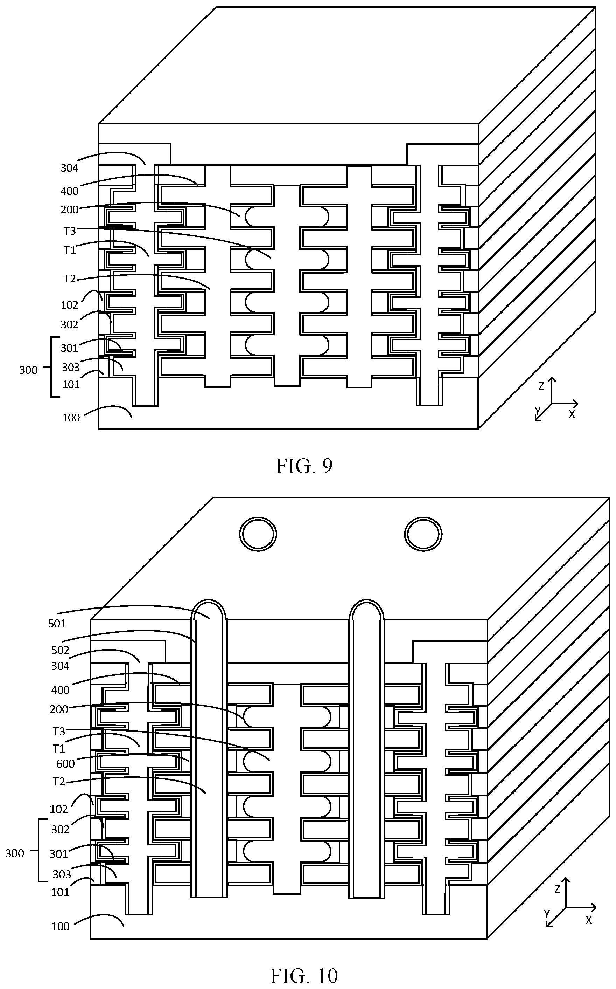

Referring to FIG. 8 and FIG. 9, in some embodiments, in a process of depositing and forming the upper electrode layer 303, a conductive material layer may be formed on the stacked structure of the first dielectric layer 101 and the second dielectric layer 102 and is polished and flattened, and a mask layer is formed on the conductive material layer to form a capacitor wire 304 through patterned etching. The capacitor wire 304 is connected to the upper electrode layer 303, is located at the upper electrode layer 303, and is connected to multiple upper electrode layers 303 arranged in the second direction. In some embodiments, the capacitor wire 304 may be formed integrally with the upper electrode layer 303. The material of the capacitor wire 304 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like.

Referring to FIG. 10, in some embodiments, a mask layer is deposited on the stacked structure of the first dielectric layer 101 and the second dielectric layer 102, and the word line through-hole T2 is re-opened through patterned etching, or the word line through-hole T2 is re-opened by selectively etching and removing the sacrificial material in the word line through-hole T2. In some embodiments, in a process of re-opening to form the word line through-hole T2, an etching condition is adjusted and a part of the second dielectric layer 102 around the word line through-hole T2 is selectively etched and removed, to expose the bit line 200 and the lower electrode layer 301 in the first direction (e.g., the X direction). In some embodiments, a gap left by the removed part of the second dielectric layer 102 has an annular horizontal cross-section surrounding the word line through-hole T2, and the annular horizontal cross-section may be in a shape of a circle, an oval, a square, or another polygon. A semiconductor material is deposited in the gap left by the removed part of the second dielectric layer 102 to form a channel layer 600. The channel layer 600 conformally covers a sidewall of the gap left by the removed part of the second dielectric layer 102. Multiple channel layers 600 are spaced apart from each other in the direction (e.g., the Z direction) perpendicular to the substrate, and the multiple channel layers 600 and multiple protective layers 400 are alternately stacked in the direction (e.g., the Z direction) perpendicular to the substrate. The channel layer 600 has an annular horizontal cross-section, which may be in a shape of, e.g., a circle, an oval, a square, or another polygon. In some embodiments, the material of the channel layer 600 may be single-crystal silicon, polysilicon, doped polysilicon, doped single-crystal silicon, germanium-silicon, doped germanium-silicon, or the like. In some embodiments, the material of the channel layers 600 may include an oxide semiconductor material, a group IV semiconductor material, a group III-V compound semiconductor material, an epitaxial semiconductor material, or a two-dimensional semiconductor material. For example, the material may include an oxide semiconductor material such as an In-Ga oxide (IGO), an In-Zn oxide (IZO), or an In-Ga-Zn oxide (IGZO); may include a group IV semiconductor material such as Si or Ge; may include a group III-V compound semiconductor material such as gallium arsenide (GaAs), indium arsenide (InAs), or indium phosphide (InP); may include an epitaxial semiconductor material formed through a selective epitaxial growth (EG) process; and may include a two-dimensional semiconductor material such as MoS₂, MoSe₂, ReS₂, HfSe₂, InSe, GeSe, WSe₂, graphene, or carbon nanotube. In some embodiments, the channel region 600 may be doped with a variety of ions, such as boron ions, nitrogen ions, phosphorus ions, or other metal ions. One end of the channel region 600 connected to the bit line has a first doped region, and the other end of the channel region connected to the capacitor 300 has a second doped region. The first doped region and the second doped region may respectively reduce resistance at the connection to the capacitor and the bit line. A method for forming the channel layer 600 may include chemical vapor deposition (Chemical Vapor Deposition, CVD), an atomic layer deposition (Atomic Layer Deposition, ALD) process, plasma enhanced ALD, physical vapor deposition (Physical Vapor Deposition, PVD), plasma enhanced chemical vapor deposition (Plasma Enhanced Chemical Vapor Deposition, PECVD), low pressure chemical vapor deposition (Low Pressure Chemical Vapor Deposition, LPCVD), or the like. In some embodiments, an atomic layer deposition (Atomic Layer Deposition, ALD) process may be randomly utilized to form a channel layer material on a sidewall of the word line through-hole T2, and then a channel material on the sidewall of the word line through-hole T2 is etched and removed. Because the channel material is formed in the gap left by the removed part of the second dielectric layer 102, the channel material is not etched, and the channel layer 600 that is stacked alternately with the protective layer 400 in the direction (e.g., the Z direction) perpendicular to the substrate is formed.

With continued reference to FIG. 2, FIG. 3, and FIG. 10, in some embodiments, in an etching process of re-opening the word line through-hole T2, an etching condition may be further adjusted and a part of the protective layer 400 around the word line through-hole T2 is selectively etched and removed. In some embodiments, a gap left by the removed part of the protective layer 400 has an annular horizontal cross-section surrounding the word line through-hole T2, and the annular horizontal cross-section may be in a shape of a circle, an oval, a square, or another polygon. A conductive material is filled in the word line through-hole, and is polished and flattened to form a word line 501. The word line 501 extends in the direction (e.g., the Z direction) perpendicular to the substrate 100, and is distributed in an array on the substrate. A horizontal cross-section of the word line 501 may be in a shape of a circle, an oval, a square, or another polygon pattern. In some embodiments, the word line further includes multiple protrusions in the direction perpendicular to the substrate, the channel layers 600 are located between adjacent protrusions, and the multiple protrusions and the channel layers 600 are disposed alternately at intervals, so that the width of the horizontal cross-section of the word line can be increased, conductive resistance of the word line can be reduced, a manufacturing window of the word line can be increased, and stability of the word line can be improved. The word line 501 is a material with conductive performance, for example, may be at least one of the following materials: single-crystal silicon, polysilicon, doped polysilicon, doped single-crystal silicon, germanium-silicon, doped germanium-silicon, titanium nitride (TiN), tungsten (W), nickel (Ni), platinum (Pt), titanium (Ti), tungsten nitride (WN), ruthenium (Ru), ruthenium oxide (RuOₓ), iridium (Ir), iridium oxide (IrOₓ), tantalum nitride (TaN), cobalt (Co), aluminum (Al), copper (Cu), metal silicide, and the like. In some embodiments, the word line 501 may include multiple layers, for example, further including a conductive barrier layer.

With continued reference to FIG. 2, FIG. 3, and FIG. 10, in some embodiments, before the word line conductive material is filled in, a gate oxide layer 502 may be further deposited. The gate oxide layer 502 is disposed surrounding the word line 501, and conformally covers the word line 501. The gate oxide layer 502 may include at least one material selected from a high k dielectric material or ferroelectric material with a dielectric constant higher than a dielectric constant of silicon oxide. In some embodiments, the gate oxide layer 502 may include at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), hafnium zirconium oxide (HfZrO), hafnium zirconium oxynitride (HfZrON), tantalum oxide (TaO), titanium oxide (TiO), barium strontium titanium oxide (BaSrTiO), barium titanium oxide (BaTiO), lead zirconium titanate (PZT), strontium bismuth tantalum (SBT), bismuth iron oxide (BFO), strontium titanium oxide (SrTiO), yttrium oxide (YO), aluminum oxide (AlO), or lead oxide scandium tantalum (PbScTaO). In some embodiments, the gate oxide layer 502 may include a metal oxide containing a dopant. For example, the dopant may include at least one of zirconium (Zr), gadolinium (Gd), lanthanum (La), silicon (Si), or aluminum (Al), but is not limited thereto. In some examples, the gate oxide layer 502 may include hafnium oxide with a specific concentration of dopant.

With continued reference to FIG. 1, in some embodiments, a mask layer is formed on the stacked structure of the first dielectric layer 101 and the second dielectric layer 102, the bit line groove T3 is re-opened through patterned etching. The bit line groove T3 runs through the stacked structure of the first dielectric layer 101 and the second dielectric layer 102, and segments the stacked structure of the first dielectric layer 101 and the second dielectric layer 102 in the first direction (e.g., the X direction). An insulating material is filled in the bit line groove T3, and is polished and flattened to form an isolation layer 700. The isolation layer 700 is located on the substrate 100, and isolates adjacent bit lines 200 in the first direction (e.g., the X direction X). The material of the isolation layer 700 may be one or more of silicon oxide, silicon nitride, silicon oxynitride, silicon carbide, or silicon carbonitride. In another embodiment, there may further be an air gap in the isolation layer 700, and the air gap may reduce parasitic capacitance between adjacent bit lines 200.

In a three-dimensional memory, the protective layer 400 is first formed, then a capacitor 300 is formed, and finally, the channel layer 600 and the word line 501 are formed, where the protective layer is located around the channel layer 600. Therefore, a manufacturing process of the capacitor 301 can be isolated from manufacturing process of the bit line 200 and the isolation layer 700. In addition, the channel layer 600 can be prevented from being affected by a thermal budget of a capacitor manufacturing process, thereby improving a density and performance of the three-dimensional memory, and reducing manufacturing difficulty of the three-dimensional memory.

The technical features in the foregoing embodiments may be combined arbitrarily. For brevity of description, not all possible combinations of these technical features in the foregoing embodiments are described. However, as long as these combinations of technical features are not contradictory, they should all be considered within the scope described in the specification.

The foregoing embodiments represent only several implementations of this application, and are described in a relatively specific and detailed way, but should not be construed as limitations on the patent scope of this application. It should be noted that a person of ordinary skill in the art can further make several variations and improvements without departing from the concept of this application, and these variations and improvements shall fall within the protection scope of this application. Therefore, the patent protection scope of this application shall be subject to the appended claims.

## Claims

1. A semiconductor device, comprising:
a word line (501), the word line (501) extending in a direction perpendicular to a substrate (100);
a plurality of channel layers (600), the plurality of channel layers (600) surrounding the word line (501) and each having an annular horizontal cross-section surrounding the word line (501) in a top view, and the plurality of channel layers (600) being spaced apart from each other in the direction perpendicular to the substrate (100);
a plurality of bit lines (200), the plurality of bit lines (200) each being disposed at one end of each of the plurality of channel layers (600) in a first direction, extending in a second direction, and being spaced apart from each other in the direction perpendicular to the substrate (100), and the first direction and the second direction being perpendicular to each other;
a plurality of capacitors (300), the plurality of capacitors (300) each being disposed at the other end of each of the plurality of channel layers (600) in the first direction and each having an annular horizontal cross-section in a top view, and the plurality of capacitors (300) being spaced apart from each other in the direction perpendicular to the substrate (100); and
a plurality of protective layers (400), the plurality of protective layers (400) being disposed between two capacitors (300) adjacent to each other in the direction perpendicular to the substrate (100), and being located at ends that are of the plurality of capacitors (300) and that are close to the plurality of channel layers (600) in the first direction.

2. The semiconductor device according to claim 1, wherein
the plurality of capacitors (300) comprises:
a plurality of lower electrode layers (301), the plurality of lower electrode layers (301) being respectively electrically connected to the plurality of channel layers (600), the plurality of lower electrode layers (301) each having an annular horizontal cross-section, and the plurality of lower electrode layers (301) each comprising a vertical section with a U shape rotated by 90 degrees;
an upper electrode layer (303), the upper electrode layer (303) extending in the direction perpendicular to the substrate (100) and being located in annular holes of the plurality of lower electrode layers (301); and
a capacitor dielectric layer (302), the capacitor dielectric layer (302) being located between the plurality of lower electrode layers (301) and the upper electrode layer (303).

3. The semiconductor device according to claim 2, wherein
the upper electrode layer (303) comprises a plurality of first protrusions (3031) located in the U shapes rotated by 90 degrees in the plurality of lower electrode layers (301), the plurality of first protrusions (3031) each have an annular horizontal cross-section, and U-shaped grooves of the lower electrode layers (301) conformally cover the first protrusions (3031).

4. The semiconductor device according to claim 3, wherein
the upper electrode layer (303) further comprises a plurality of second protrusions (3032), the plurality of second protrusions (3032) are disposed between the plurality of lower electrode layers (301) in the direction perpendicular to the substrate (100), the plurality of second protrusions (3032) each have a horizontal cross-section of a sector shape, and a central angle of the sector shape faces a direction away from the capacitors (300).

5. The semiconductor device according to any one of claims 2 to 4, wherein
the plurality of protective layers (400) are disposed between the plurality of lower electrode layers (301) in the direction perpendicular to the substrate (100), and the plurality of protective layers (400) are alternately disposed with the plurality of lower electrode layers (301).

6. The semiconductor device according to claim 5, wherein
the plurality of protective layers (400) each comprise a vertical section with a U shape rotated by 90 degrees, and an opening direction of the U-shaped vertical section of each of the plurality of protective layers (400) is opposite to an opening direction of the U-shaped vertical section of each of the plurality of lower electrode layers (301) in the first direction.

7. The semiconductor device according to any one of claims 4 to 6, wherein
the capacitor dielectric layer (302) conformally overlaps surfaces of the first protrusions (3031) and the second protrusions (3032) of the upper electrode layer (303).

8. The semiconductor device according to any one of claims 5 to 7, wherein
a horizontal section of the word line (501) has a circular shape or an oval shape, the word line (501) has a cross-section with a plurality of protrusions in the direction perpendicular to the substrate (100), and the plurality of channel layers (600) surround the word line (501) and are disposed between the plurality of protrusions.

9. The semiconductor device according to any one of claims 5 to 8, wherein
each of the channel layers (600) comprises an oxide semiconductor material, a group IV semiconductor material, a group III-V compound semiconductor material, an epitaxial semiconductor material, or a two-dimensional semiconductor material.

10. The semiconductor device according to claim 5, wherein
each of the channel layers (600) comprises a first doped region at one end in contact with a bit line and a second doped region at the other end in contact with a capacitor in the first direction.

11. A manufacturing method for a semiconductor device, comprising:
providing a substrate (100), and forming a word line (501) on the substrate (100), the word line (501) extending in a direction perpendicular to the substrate (100);
forming a plurality of channel layers (600), the plurality of channel layers (600) surrounding the word line (501) and each having an annular horizontal cross-section surrounding the word line (501) in a top view, and the plurality of channel layers (600) being spaced apart from each other in the direction perpendicular to the substrate (100);
forming a plurality of bit lines (200), the plurality of bit lines (200) each being disposed at one end of each of the plurality of channel layers (600) in a first direction, extending in a second direction, and being spaced apart from each other in the direction perpendicular to the substrate (100), and the first direction and the second direction being perpendicular to each other;
forming a plurality of capacitors (300), the plurality of capacitors (300) each being disposed at the other end of each of the plurality of channel layers (600) in the first direction and each having an annular horizontal cross-section in a top view, and the plurality of capacitors (300) being spaced apart from each other in the direction perpendicular to the substrate (100); and
forming a plurality of protective layers (400), the plurality of protective layers (400) being disposed between two capacitors (300) adjacent to each other in the direction perpendicular to the substrate (100), and being located at ends that are of the plurality of capacitors (300) and that are close to the plurality of channel layers (600) in the first direction.

12. The manufacturing method for a semiconductor device according to claim 11, wherein
before the forming the bit line (200), the method comprises:
providing the substrate (100), and forming a stacked structure in which a plurality of first dielectric layers and second dielectric layers are alternately stacked on the substrate (100); and
etching the stacked structure to form a bit line groove (T3), and forming the bit line (200) in the bit line groove (T3).

13. The manufacturing method for a semiconductor device according to claim 12, wherein the forming a capacitor comprises:
etching the stacked structure to form a capacitor through-hole (T1) and a word line through-hole (T2), forming a plurality of lower electrode layers (301) in the capacitor through-hole (T1), and forming a plurality of protective layers (400) in the word line through-hole (T2); and
forming a capacitor dielectric layer (302) and an upper electrode layer (303) in the capacitor through-hole.

14. The manufacturing method for a semiconductor device according to claim 13, wherein the forming a word line (501) comprises:
forming a plurality of channel layers (600) and filling a word line conductive material in the word line through-hole (T2).
